# FASCICULE DE BREVET EUROPEEN

(11) **EP 0 279 497 B1**
(45) Date de publication et mention de la délivrance du brevet: **26.05.1993**
(21) Numéro de dépôt: 88200280.1
(22) Date de dépôt: 16.02.1988
(51) Int. Cl.: H01L 29/205, H01L 23/52

(54) **Circuit comportant des lignes conductrices pour le transfert de signaux rapides**
Schaltkreis mit Leiterbahnen zur Übertragung von schnellen Signalen
Circuit with conducting lines for the transfer of fast signals

(30) Priorité: 20.02.1987 FR 8702233
(43) Date de publication de la demande: 24.08.1988
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Patillon, Jean-Noel Société Civile S.P.I.D., F-75007 Paris (FR); Gabillard, Bertrand Société Civile S.P.I.D., F-75007 Paris (FR); Martin, Gérard Marie Société Civile S.P.I.D., F-75007 Paris (FR)
(74) Mandataire: Landousy, Christian

(56) Documents cités:
- EP-A- 0 208 294
- DE-A- 2 913 068
- APPLIED PHYSICS LETTERS, vol. 48, no. 20, 19 mai 1986, pages 1392-1394, American Institute of Physics, Woodbury, New York, US; K. PLOOG et al.: "High-throughput high-yield fabrication of selectively doped AlxGa1-xAs/GaAs heterostructures by molecular beam epitaxy"

## Description

La présente invention concerne un circuit intégré comportant un corps semiconducteur avec une pluralité d'éléments de circuit et d'interconnexions entre lesdits éléments de circuit.

Des circuits comportant des lignes conductrices pour le transfert de signaux rapides sont couramment utilisés et connus en soi. En effet tout matériau conducteur permet de véhiculer des signaux, que ceux-ci soient à faible vitesse ou à grande vitesse. Cependant lorsque lesdits signaux comportent des flancs de montée très raides, un grave inconvénient apparaît, le matériau conducteur de par sa résistance R et sa capacité C va intégrer les flancs de montée selon la constante de temps RC, c'est-à-dire que les flancs seront "avachis" et que de plus un retard sera imposé à la circulation des signaux. En outre, des progrès technologiques considérables sont réalisés dans la conception et la réalisation des circuits et dispositifs électroniques actuels, les temps d'accès à ces circuits dispositifs sont de plus en plus réduits et leurs vitesses de fonctionnement de plus en plus élevées. Pour ne pas compromettre de tels avantages, il est donc essentiel que les lignes conductrices accédant aux entrées et sorties de ces dits circuits et dispositifs soient capables d'assurer la transmission des signaux avec une extrême célérité et sans déformation.

La présente invention propose un moyen efficace pour éviter l'inconvénient précité.

Pour cela et dans le but d'autoriser à des transmissions et des fonctionnements de circuits ultra-rapides, le circuit décrit dans le préambule est remarquable en ce que ledit corps semiconducteur présente une structure de couches superposées avec au moins une première couche semiconductrice à une première largeur de bande interdite et une seconde couche semiconductrice à une seconde largeur de bande interdite supérieure à ladite première largeur de bande interdite, lesdites première et seconde couches semiconductrices formant entre elles une interface et un gaz de porteurs électroniques bidimensionnel formant un chemin de courant au voisinage de ladite interface, dans laquelle en appliquant une composante de champ magnétique suffisamment intense perpendiculairement à ladite interface et pour une température suffisamment basse ledit chemin de courant devient supraconducteur de telle sorte qu'au moins la résistance longitudinale dudit chemin de courant soit réduite pratiquement à zéro, ledit chemin de courant formant une ligne conductrice pour la transmission de signaux entre lesdits éléments du circuit. Ainsi dans des conditions de température et de champ magnétique prédéterminées le matériau dudit circuit est rendu supraconducteur, la résistance longitudinale des lignes conductrices devenant quasi-nulle, la conduction est quasi-idéale c'est-à-dire que les signaux appliqués à ces lignes peuvent se propager pratiquement à la vitesse de lumière dans le milieu considéré. De ce fait, les retards et déformations de signaux constatés lors de la propagation de ceux-ci dans des matériaux conducteurs traditionnels sont supprimés et les circuits ou dispositifs électroniques ultra-rapides peuvent alors être potentiellement utilisés sans limitation de leurs performances.

En outre, il est important de souligner que le circuit selon l'invention utilisé dans les conditions précitées bénéficie d'un autre avantage capital. En effet il a été constaté lors d'expériences en laboratoire que la résistance transversale de chacune des lignes conductrices tend vers l'infini ce qui signifie que toute ligne conductrice est parfaitement isolée de son environnement.

Un circuit intregré comportant une structure semiconductrice à la partie précaractérisante de la revendication 1 est connu de DE-A-2 913 068.

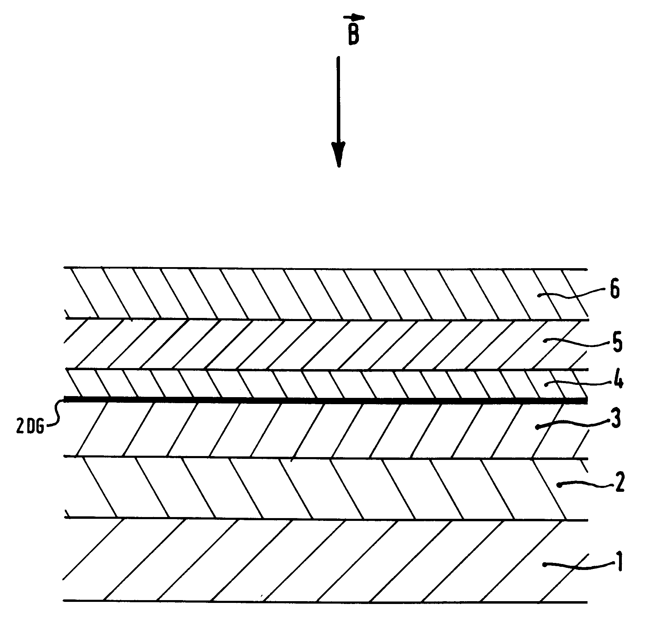

La description suivante en regard du dessin annexé, le tout donné à titre d'exemple, fera bien comprendre comment l'invention peut être réalisée.

La figure unique représente une structure possible du matériau du circuit en coupe transversale.

Le matériau doit présenter un gaz de porteurs électroniques (électrons ou trous) à deux dimensions, il est réalisé à partir de l'empilement de couches d'un matériau à faible bande interdite et d'un matériau à plus grande bande interdite (ou réciproquement). Le gaz bidimensionnel est situé à l'interface de ces deux couches et la présence de ce gaz rend le matériau semi-conducteur. Une grande variété de matériaux et notamment les matériaux III-V (convenant particulièrement à cette application) incluant leurs alliages ternaires et quaternaires autorise à un grand nombre de combinaisons desdits matériaux. Selon une réalisation préférée du circuit selon l'invention le choix s'est porté sur une combinaison du type AlGaAs/GaAs. Cependant, il est bien évident que ce choix n'est pas limitatif, d'autres combinaisons pourraient parfaitement convenir telles que par exemple :

InP/GaInAs

GaAs/GaInAs

AlGaInAs/GaInAs

AlInAs/GaInAs

GaInP/GaAs

etc...

Ainsi sur la figure est représentée en coupe transversale la structure épitaxiale du circuit comportant les lignes conductrices.

La structure épitaxiale est obtenue sur une couche 1 de substrat de GaAs semi-isolant dopé chrome, elle est constituée d'une couche 2 de AlGaAs non dopé d'épaisseur L2 (0,5µm≦L2≦1µm), d'une couche 3 de GaAs non dopé d'épaisseur L3 (0,5µm≦L3≦1µm), d'une couche fine 4 de AlGaAs non dopé d'épaisseur L4 (2nm≦L4≦10nm), d'une couche 5 de AlGaAs dopé silicium d'épaisseur L5 (5nm≦L5≦50nm, N_{D5}≈10¹⁸cm⁻³) et finalement d'une couche 6 de GaAs dopé silicium d'épaisseur L6 (5nm≦L6≦50nm, N_{D6}≈10¹⁸cm⁻³), (1nm=10Å). Le gaz bidimensionnel référencé 2DG est localisé à l'hétérojonction des couches 3 et 4. Les épaisseurs des couches 4 et 5 ainsi que le dopage de la couche 5 sont choisis de sorte que la densité d'électrons du gaz à deux dimensions n_{2D} soit de l'ordre de 3.10¹¹cm⁻².

Cette densité d'électrons correspond à l'obtention du plateau de Hall correspondant au deuxième sous-niveau de Landau du gaz bidimensionnel rempli pour un champ magnétique 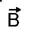 dont l'induction est inférieure à 7 Tesla, l'effet étant obtenu pour ce plateau (le champ magnétique étant appliqué perpendiculairement aux lignes conductrices). Il est entendu que la présente invention peut s'étendre à des concentrations de gaz plus élevées ainsi qu'à des plateaux de Hall obtenus à des champs plus intenses.

D'autre part afin d'obtenir une conduction quasi-idéale, en combinaison avec les autres caractéristiques la température est maintenue basse. Dans l'exemple de réalisation choisi, elle était de l'ordre de quelques °K (4,2°K).

De tels effets sont clairement décrits dans un certain nombre d'ouvrages ou de publications, par exemple par H.L Störmer dans "Surface Science 142" (ELSEVIER, 1984) Novel Physics in two dimensions, pages 130 à 146, en particulier page 137 paragraphe 3.3.

A partir du matériau ainsi obtenu, il est possible de réaliser des lignes conductrices de forme quelconque et ceci suivant plusieurs procédés connus :
- par implantation ionique (par exemple de Bore, d'Hydrogène...) en dehors des lignes conductrices pour rendre le matériau non conducteur (ou à conduction 3 dimensions)
- par implantation ionique et recuit en dehors des lignes conductrices (destruction partielle)
- par diffusion localisée en dehors des lignes conductrices
- par décapage chimique ou ionique etc...

En fait, il est procédé à une destruction totale ou partielle du matériau en dehors des lignes pour ne laisser subsister que les lignes désirées.

Un tel circuit comportant des lignes conductrices est aisé à réaliser, il trouve particulièrement et avantageusement bien sa place dans de nouvelles applications, notamment dans la mise en oeuvre d'un super ordinateur, où il est trouvé naturellement l'environnement (champ magnétique, basse température) nécessaire à l'obtention de l'effet supraconducteur.

## Revendications

1. Circuit intégré comportant un corps semiconducteur avec une pluralité d'éléments de circuit et d'interconnexions entre lesdits éléments de circuit, ledit corps semiconducteur présentant une structure de couches superposées avec au moins une première couche semiconductrice ayant une première largeur de bande interdite et une seconde couche semiconductrice ayant une seconde largeur de bande interdite supérieure à ladite première largeur de bande interdite, lesdites première et seconde couches semiconductrices formant entre elles une interface et un gaz de porteurs électroniques bidimensionnel formant un chemin de courant au voisinage de ladite interface, caractérisé en ce que ledit chemin de courant est supraconducteur de telle sorte qu'au moins la résistance longitudinale dudit chemin de courant est réduite pratiquement à zéro, et qu'une composante de champ magnétique suffisamment intense perpendiculairement à ladite interface est appliquée au corps semiconducteur à une température suffisamment basse et en ce que ledit chemin de courant forme une ligne conductrice pour la transmission de signaux entre lesdits éléments du circuit.

2. Circuit intégré selon la revendication 1, caractérisé en ce que ladite première couche semiconductrice comporte au moins un matériau semiconducteur du groupe arséniure de gallium et arséniure de gallium indium et en ce que ladite seconde couche semiconductrice comporte au moins un matériau semiconducteur du groupe phosphure d'indium, arséniure d'indium gallium, arséniure d'indium gallium aluminium, arséniure d'indium aluminium et phosphure d'indium gallium.

3. Circuit intégré selon la revendication 1, caractérisé en ce que lesdites interconnexions sont latéralement limitées par une région semiconductrice implantée.

4. Circuit intégré selon la revendication 1 ou 2 caractérisé en ce que lesdites interconnexions sont latéralement limitées par une région semiconductrice diffusée.

5. Circuit intégré selon l'une quelconque des revendications 1 à 4 caractérisé en ce que ladite composante de champ magnétique est inférieure à 7 Tesla.

6. Circuit intégré selon l'une quelconque des revendications 1 à 5 caractérisé en ce que le gaz de porteurs bidimensionnel est un gaz d'électrons dont la densité d'électrons est de l'ordre de 3x10¹¹cm⁻².

7. Circuit intégré selon l'une quelconque des revendications 1 a 6 caractérisé en ce que la structure de couches superposées comprend un substrat semi-isolant, une couche non dopée d'arséniure de gallium aluminium d'épaisseur L2, 0,5µm≦L2≦1µm, une couche non dopée d'arséniure de gallium d'épaisseur L3, 0,5µm≦L3≦1µm, une couche non dopée d'arséniure de gallium aluminium d'épaisseur L4, 2nm≦L4≦10nm, une couche d'arséniure de gallium aluminium dopée silicium, de dopage N_{D5} 10¹⁸≃cm⁻³ et d'épaisseur L5, 5nm≦L5≦50nm et une couche d'arséniure de gallium dopée silicium, de dopage N_{D6}≃10¹⁸cm⁻³ et d'épaisseur L6, 5nm≦L6≦50nm.

## Claims

1. An integrated circuit comprising a semiconductor body with a plurality of circuit elements and interconnections between said circuit elements, which semiconductor body comprises a stratified structure with at least a first semiconductor layer having a first bandgap and a second semiconductor layer having a second bandgap greater than said first bandgap, said first and second semiconductor layers forming an interface between them and a two-dimensional charge carrier gas forming a current path near said interface, characterized in that said current path is superconducting so that at least the longitudinal resistance of said current path is reduced substantially to zero, and in that a sufficiently high magnetic field component perpendicular to said interface is applied to the semiconductor body at a sufficiently low temperature, and in that the said current path forms a conductive line for the transmission of signals between the said elements of the circuit.

2. An integrated circuit as claimed in Claim 1, characterized in that said first semiconductor layer comprises at least a semiconductor material of the group of gallium arsenide and gallium-indium arsenide, and in that said second semiconductor layer comprises at least a semiconductor material of the group of indium phosphide, gallium-indium arsenide, aluminium-gallium-indium arsenide, aluminium-indium arsenide and gallium-indium phosphide.

3. An integrated circuit as claimed in Claim 1, characterized in that said interconnections are laterally bounded by an implanted semiconductor region.

4. An integrated circuit as claimed in Claim 1 or 2, characterized in that said interconnections are laterally bounded by a diffused semiconductor region.

5. An integrated circuit as claimed in any one of the preceding Claims, characterized in that said magnetic field component is lower than 7 Tesla.

6. An integrated circuit as claimed in any one of the preceding Claims, characterized in that the two-dimensional carrier gas is an electron gas with an electron density of about 3x10¹¹ cm⁻².

7. An integrated circuit as claimed in any one of the Claims 1 to 6, characterized in that the stratified structure comprises a semi-insulating substrate, an undoped gallium-aluminium arsenide layer having a thickness L2, 0.5 µm ≦ L2 ≦ 1 µm, an undoped gallium arsenide layer having a thickness L3, 0.5 µm ≦ L3 ≦ 1 µm, an undoped gallium-aluminium arsenide layer having a thickness L4, 2 nm ≦ L4 ≦ 10 nm, a silicon-doped gallium-aluminium arsenide layer with a doping level N_{D5} ≈ 10¹⁸ cm⁻³ and a thickness L5, 5 nm ≦ L5 ≦ 50 nm, and a silicon-doped gallium arsenide layer with a doping level N_{D6} ≈ 10¹⁸ cm⁻³ and a thickness L6, 5 nm ≦ L6 ≦ 50 nm.

## Patentansprüche

1. Integrierte Schaltung mit einem Halbleiterkörper mit einer Anzahl Schaltungselemente und Verbindungen zwischen diesen Schaltungselementen, wobei der Halbleiterkörper eine Struktur aus übereinanderliegenden Schichten aufweist, mit mindestens einer ersten Halbleiterschicht mit einem ersten Bandabstand und einer zweiten Halbleiterschicht mit einem zweiten Bandabstand, der größer als der erste Bandabstand ist, wobei die erste und die zweite Halbleiterschicht miteinander eine Zwischenschicht bilden und ein zweidimensionales Ladungsträgergas einen Stromkanal in der Nähe dieser Zwischenschicht bildet, dadurch gekennzeichnet, daß der Stromkanal supraleitend ist, so daß mindestens der longitudinale Widerstand des Stromkanals praktisch auf Null reduziert ist, und daß eine ausreichend starke Magnetfeldkomponente senkrecht zu dieser Zwischenschicht bei genügend niedriger Temperatur an dem Halbleiterkörper anliegt und daß der Stromkanal eine Leiterbahn für die Übertragung von Signalen zwischen den Schaltungselementen bildet.

2. Integrierte Schaltung nach Anspruch 1, dadurch gekennzeichnet, daß die erste Halbleiterschicht mindestens ein Halbleitermaterial aus der Galliumarsenid- und der Galliumindiumarsenid-Gruppe enthält und daß die zweite Halbleiterschicht mindestens ein Halbleitermaterial aus der Indiumphosphid-, Indiumgalliumarsenid, Indiumgalliumaluminiumarsenid, Indiumaluminiumarsenid- und Indiumgalliumphosphid-Gruppe enthält.

3. Integrierte Schaltung nach Anspruch 1, dadurch gekennzeichnet, daß die genannten Verbindungen seitlich von einer implantierten Halbleiterzone begrenzt werden.

4. Integrierte Schaltung nach Anspruch 1 oder 2, dadurch gekennzeichnet, daß die genannten Verbindungen seitlich von einer diffundierten Halbleiterzone begrenzt werden.

5. Integrierte Schaltung nach einem der Ansprüche 1 bis 4, dadurch gekennzeichnet, daß die Magnetfeldkomponente Kleiner als 7 Tesla ist.

6. Integrierte Schaltung nach einem der Ansprüche 1 bis 5, dadurch gekennzeichnet, daß das zweidimensionale Trägergas ein Elektronengas mit einer Elektronendichte von etwa 3·10¹¹ cm⁻² ist.

7. Integrierte Schaltung nach einem der Ansprüche 1 bis 6, dadurch gekennzeichnet, daß die Struktur von übereinanderliegenden Schichten ein halbisolierendes Substrat, eine undotierte Galliumaluminiumarsenid-Schicht der Dicke L2, 0,5 µm ≦ L2 ≦ 1 µm, eine undotierte Galliumarsenid-Schicht der Dicke L3, 0,5 µm ≦ L3 ≦ 1 µm, eine undotierte Galliumaluminiumarsenid-Schicht der Dicke L4, 2 nm ≦ L4 ≦ 10 nm, eine siliciumdotierte Galliumaluminiumarsenid-Schicht mit einem Dotierungsgrad N_{D5} ≈ 10¹⁸ cm⁻³ und einer Dicke L5, 5 nm ≦ L5 ≦ 50 nm, und eine siliciumdotierte Galliumarsenid-Schicht mit einem Dotierungsgrad N_{D6} ≈ 10¹⁸ cm⁻³ und einer Dicke L6, 5 nm ≦ L6 ≦ 50 nm, umfaßt.
